# EUROPEAN PATENT APPLICATION

(11) **EP 0 555 970 A2**
(43) Date of publication of application: **18.08.1993**
(21) Application number: 93300593.6
(22) Date of filing: 27.01.1993
(51) Int. Cl.: H04N 7/00, H04L 25/30

(54) **Data tracking system**

(30) Priority: 10.02.1992 GB 9202733
(71) Applicant: PLESSEY SEMICONDUCTORS LIMITED, Swindon, Wiltshire SN2 2QW (GB)
(72) Inventor: Sitch, Douglas Robert, Plympton, Plymouth, Devon PL7 3YW (GB)
(74) Representative: Hoste, Colin Francis

(57) **Abstract**

A method and circuit arrangement for tracking data signals between a '0' and a '1' level uses a data slicing comparator having a pair of switched data level tracking ciruits for tracking the '0' and '1' levels respectively and combining the output from the circuits to give a single data level output for slicing incoming data signals.

## Description

This invention relates to a Data Tracking System and includes a method and a circuit for tracking data signals to achieve maximum data separation irrespective of signal level. The invention finds particular but not exclusive application to data systems where a desired stream of information has to be separated from a multi-level received signal. A typical type of separation is that of receiving a teletexed signal and separating the teletexed information from other information in a multi-feature broadcast system. It is an object of the present invention to provide an improved method and circuit for tracking data signals.

According to the first aspect of the present invention a method of tracking data signals, comprises feeding an input signal to a data slicing comparator and a pair of data level tracking circuits, one of the said data level tracking circuits tracking a "One" level of the data signal and the other tracking circuit tracking the "Zero" level, obtaining an output from each of the said data level tracking circuits and combining the outputs to give a single data level output which can be used to slice the incoming data signals.

The method may include feeding the input signal to a plurality of data level tracking circuits connected in parallel. Preferably there are a pair of such circuits but there may be more, such as four, depending on the requirements of the system in which the method is used.

The output from the data level tracking circuits are each fed to separate data slicer the output of which is then fed to a common output. Where the system includes a plurality of data level tracking circuits these may each include its own driver circuit and the driver circuits can each be enabled serially under the control of a data slicing comparator which compares the input signal to a voltage mid-way between the stored voltages.

According to the second aspect of the present invention a data tracking circuit arrangement comprises a pair of signal level tracking circuits, each signal level tracking circuit including switching means which are switched to allow tracking of the incoming signal only during such times as the sliced data output from the circuit signals the appropriate data such as '0' and '1' events. Thus in a 2-level system, the '1' level tracking circuit only tracks the incoming signal when the sliced output data is a '1' and '0' level is tracked only when the data is a '0'. The tracking circuit may use a number of means for controlling tracking performance including current limiting resistors, capacitors etc.

In order to achieve a high performance tracking system, it is necessary to cross-couple the tracking circuits such that the majority of any change to the tracked level in one circuit is passed to the other. This preserves the 'data-height' between the tracking circuits whilst allowing for each to track to the correct level.

In order that the invention may be readily understood an example of the method thereof and circuits which are suitable for employing the method will now be described with reference to the four figures of the accompanying drawings.

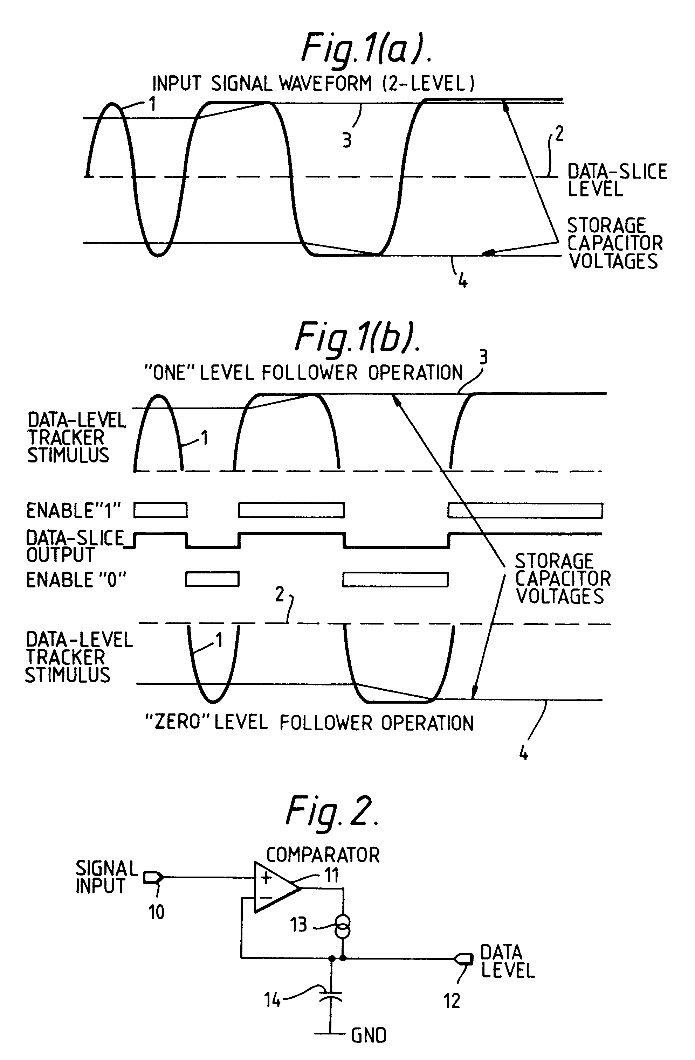

In the drawings Figure 1 illustrates the waveforms and how they are sliced by using the invention,
Figure 2 shows a data level tracking circuit in accordance with the invention, and
Figure 3 shows a data tracking circuit using the circuit of Figure 2.

Figure 4 shows a 4 level data tracking circuit as a variation to the circuit of Figure 3.

Referring first to Figure 1 this shows in Figure 1 (a) the input signal waveform 1 of generally sinusoidal form. The data slice level to be obtained is shown at 2 as a dotted line and the storage capacitor voltages shown as 3 and 4.

In the bottom part of Figure 1 (b) the data level tracker stimulus is shown for the "0" level operation and above that the enable "0" pulses are indicated.

Above this and central to Figure 1 (b) the final squared waveform for the sliced data output is shown. It will be seen that the incoming waveform 1 has been effectively sliced to give a basic logical 1 and 0 waveform.

The circuits to achieve this waveform slicing will now be described with reference to Figures 2, 3, and 4. The circuit shown in Figure 2 to which reference is now made is the basic data level tracking circuit and comprises a signal input terminal 10, a comparator 11, a data level output terminal 12 and a current limiter driver 13 which is connected between the comparator 11 and the data level terminal 12. A capacitor 14 is connected between earth and the data level terminal 12. The comparator has a second input connected also to the output from the current limiter driver 13 so as to create a feedback path. The input signal 1 is fed to terminal 10 and processed by the comparator 11 to give an output to driver 13. This output is fed back to comparator 11 and under the effect of the capacitor 14 will track the input signal 1. The final signal is taken out at data level terminal 12. The current from the driver 13 can be adjusted as required to provide any necessary "pull" towards the required peak levels of the input signal 1.

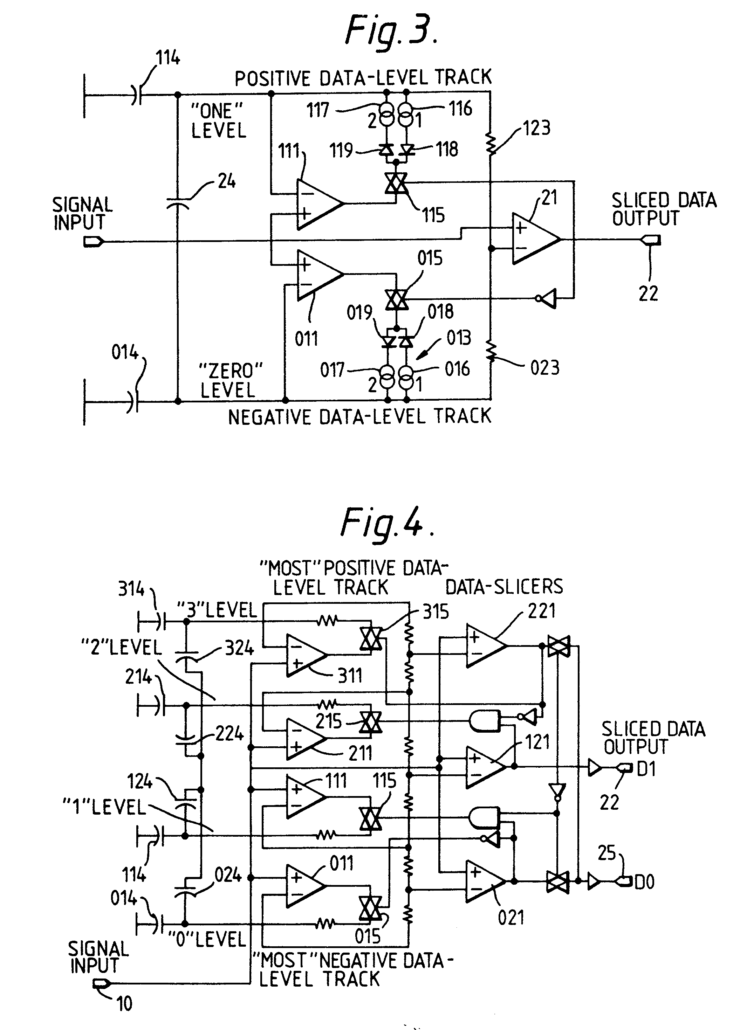

The data tracking circuit including a data level tracking circuit as shown in Figure 2 is illustrated in Figure 3 to which reference is now made. Here the top half of the circuit indicates the positive data level track i.e for the "1" level and the lower data level tracking circuit is used for the negative data level track. The positive data level track components are indicated with the preface 1 to the reference numerals given in Figure 2 and the negative data level tracking components are prefaced by the reference 0. It will be noted that the comparator in the circuit of Figure 3 is connected through a respective switch 115 and 015 to the respective current limited driver 113 and 013. Each driver in this case is of a different construction than the driver 13 of Figure 2 and includes a pair of parallel arms indicated as including a pair of diodes 018, 019 and 118, 119 connected in reverse direction to the switch 115 and 015 and with serially connected resistors 116, 117 and 016, 017 respectively. The two switches 015 and 115 are connected together via a diode 20 and to the output of a comparator 21 which is connected to an output terminal 22 which receives the sliced output data. The comparator 21 receives the signal input direct from input terminal 10 on one terminal and also receives the output from the comparators 013 and 113 via resistors 023 and 123 respectively to its other terminal.

A further capacitor 24 is connected between the two capacitors 014 and 114 on the side remote from the earthed side.

In operation the input signal 1 is fed to signal input terminal 10 and from there to one terminal of each of the comparators 011, 111 and 21. The switched output from comparators 011 and 111 are fed to the respective current limited drivers 013 and 113 via switches 015 and 115 and their output is fed to the other terminal of comparator 21. The signal is effectively sliced on both the one level and the zero level and the output is received at output terminal 22.

It will be appreciated that the simple system of Figure 3 can easily be added to by increasing the number of data level tracking circuits where more than zero and one levels are to be discriminated. An example of this is shown in Figure 4 which is a four level tracking circuit. Here the same references are used as previously except that there are now signals required at "2" and "3" levels. The necessary components are indicated by the preface 2 and 3 respectively with the most positive data level track,i.e. the "3" being shown at the top of the circuit. It will be noted that only three data slices 21, 121 and 221 are required with the four comparators 011,111,211 and 311. The outputs are received on the two terminals 22 and 25.

The signal level waveform is substantially as in Figure 1 (b) and a clean separation of enable signals is obtained.

It will be appreciated that the tracking circuits are switched so as only to be enabled during parts of the incoming data; the control of the tracking circuits is dependent on the sliced data only if;
control of the slicing level for the incoming signal is at the mid-point between the stored values of the tracking circuits, and
use of coupling between the tracking circuits ensures that changes in one tracking circuit are seen at the others, to enable tracking of moving DC levels etc.

When the above circuits and method are used for extracting teletexed data from composite video signals there is an excellent immunity given to interference. The system has the advantage that it is not susceptible to alterations in the form of the signal or its amplitude, D.C. offset or its content.

## Claims

1. A method of tracking data signals, comprising feeding an input signal to a data slicing comparator and a pair of data level tracking circuits, one of the said data level tracking circuits tracking a "One" level of the data signal and the other tracking circuit tracking the "Zero" level, obtaining an output from each of the said data level tracking circuits and combining the outputs to give a single data level output which can be used to slice the incoming data signals.

2. A method as claimed in Claim 1 including feeding the input signal to a plurality of data level tracking circuits connected in parallel.

3. A method as claimed in Claim 1 or Claim 2 including a plurality of data level tracking circuits for each level being tracked.

4. A method as claimed in any preceding claim, in which the output from the data level tracking circuits are each fed to separate data slicer the output of which is then fed to a common output.

5. A method as claimed in any preceding claim, in which the system includes a plurality of data level tracking circuits each of which includes its own driver circuit and in which the driver circuits can each be enabled serially under the control of a data slicing comparator which compares the input signal to a voltage mid-way between the stored voltages.

6. A data tracking circuit arrangement comprising a pair of signal level tracking circuits, each signal level tracking circuit including switching means which are switched to allow tracking of the incoming signal only during such times as the sliced data output from the circuit signals the appropriate data such as '0' and '1' events.

7. A circuit arrangement as claimed in Claim 6 in which there is provided a 2-level system, in which the '1' level tracking circuit is arranged only to track the incoming signal when the sliced output data is a '1' and '0' level is tracked only when the data is a '0'.

8. A circuit arrangement as claimed in Claim 6 or Claim 7 wherein tracking circuit uses a current limiting means for controlling tracking performance.

9. A circuit arrangement as claimed in Claim 8 in which the means are resistors.

10. A circuit arrangement as claimed in Claim 8 in which the means are capacitors.

11. A circuit arrangement as claimed in any one of Claims 6 to 10 in which the tracking circuits are cross-coupled such that the majority of any change to the tracked level in one circuit is passed to the other in order to preserve the 'data-height' between the tracking circuits whilst allowing for each circuit to track to the correct level.
